(19) Europäisches Patentamt
European Patent Office
Office européen des brevets

(11) **EP 4 424 867 A1**

(12) **EUROPEAN PATENT APPLICATION**
published in accordance with Art. 153(4) EPC

(43) Date of publication:
**04.09.2024 Bulletin 2024/36**

(21) Application number: **22886452.6**

(22) Date of filing: **01.09.2022**

(51) International Patent Classification (IPC):
**C23C 14/34** (2006.01)     **C04B 35/01** (2006.01)

(52) Cooperative Patent Classification (CPC):
**C04B 35/01; C23C 14/34**

(86) International application number:
**PCT/JP2022/033015**

(87) International publication number:
**WO 2023/074118 (04.05.2023 Gazette 2023/18)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **29.10.2021 JP 2021178111**

(71) Applicant: **JX Metals Corporation
Tokyo 105-8417 (JP)**

(72) Inventors:
• **MURAI, Kazutaka
Kitaibaraki-shi, Ibaraki 319-1535 (JP)**
• **OSADA, Kozo
Kitaibaraki-shi, Ibaraki 319-1535 (JP)**

(74) Representative: **Mewburn Ellis LLP
Aurora Building
Counterslip
Bristol BS1 6BX (GB)**

(54) **IGZO SPUTTERING TARGET**

(57)     An IGZO sputtering target with high relative density while suppressing increase in arcing and particle during sputtering is provided. An IGZO sputtering target includes indium (In), gallium (Ga), zinc (Zn), zirconium (Zr), and oxygen (O), the rest consisting of inevitable impurities, wherein the IGZO sputtering target includes Zr at less than 20 mass ppm and has a relative density is 95% or more.

EP 4 424 867 A1

**Description**

**FIELD OF THE INVENTION**

The present invention relates to an IGZO sputtering target. In particular, the present invention relates to an IGZO sputtering target that can achieve high relative density while reducing the zirconium content.

**BACKGROUND OF THE INVENTION**

Conventionally, $\alpha$-Si (amorphous silicon) has been used for TFTs (thin film transistors) of backplanes in FPDs (flat panel displays). However, sufficient electron mobility cannot be obtained with $\alpha$-Si, and in recent years, research and development of TFTs using In-Ga-Zn-O-based oxide (IGZO), which has higher electron mobility than $\alpha$-Si, has been carried out. Some next-generation high-performance flat panel displays using IGZO-TFT have been put into practical use and are attracting attention.

An IGZO film is mainly formed by sputtering a target made from a sputtering target such as an IGZO sintered body. When particles are generated when forming a thin film by sputtering, they cause pattern defects and the like. The most common cause of these particles is abnormal discharge (arcing) that occurs during sputtering. In particular, when arcing occurs on the target surface, the target material around where the arcing occurs is ejected from the target in the form of clusters (lumps). This clustered target material then adheres to the substrate.

Further, due to problems with display accuracy in recent years, there are stricter requirements than ever before regarding particles during sputtering. In order to solve such problems during sputtering, attempts have been made to obtain a high-strength target by increasing the density of the target or controlling crystal grains.

Patent Literature 1 (Japanese Patent Application Publication No. 2014-024738) discloses an oxide sintered body comprising In, Ga, and Zn, having a homologous crystal structure represented by $InGaZnO_4$, and containing zirconium in a weight ratio of 20 ppm or more and less than 100 ppm. It is disclosed that by containing zirconium in a weight ratio of 20 ppm or more and less than 100 ppm in a sintered body having a homologous crystal structure represented by $InGaZnO_4$, the relative density of the sintered body can be increased to 95% or more, and the bending strength can be increased to 100 MPa or more, and in addition, the IGZO film obtained by sputtering using this sintered body shows superior transmittance compared to that without adding zirconium.

Further, Patent Literature 2 (Japanese Patent Application Publication No. 2015-024944) discloses an oxide sintered body containing at least In, Ga, and Zn, characterized in that it has a homologous crystal structure represented by $InGaZnO_4$, the crystal grain size of the oxide sintered body is 5 $\mu$m or less, the relative density is 95% or more, and the bending strength of the oxide sintered body is 100 MPa or more. It is described that by controlling the crystal grain size, relative density, and bending strength of the sintered body to predetermined values, it not only improves the yield in manufacturing large-sized targets required by mass production equipment, but also suppresses the occurrence of cracks during sputtering even when used as a cylindrical sputtering target that can input high power.

Further, in Patent Literature 3 (Japanese Patent Application Publication No. 2007-223849) discloses a gallium oxide-based sintered body represented by the formula $GaInM_xO_y$ (M is a metal element with a positive valence of 2 or more, x is an integer of 1 to 3, and y is an integer of 4 to 8), characterized in that the density of the sintered body is 95% or more in relative density, there is no insulating phase of $Ga_2O_3$, and the average crystal grain size is 10 $\mu$m or less. When the gallium oxide-based sintered body is used, the generation of cracks and nodules in the sputtering target during DC sputtering is suppressed, and since abnormal discharges are less likely to occur, it becomes possible to form a high-quality transparent thin film efficiently, inexpensively, and with energy savings.

**PRIOR ART**

Patent Literature

[Patent Literature 1] Japanese Patent Application Publication No. 2014-024738

[Patent Literature 2] Japanese Patent Application Publication No. 2015-024944

[Patent Literature 3] Japanese Patent Application Publication No. 2007-223849

## SUMMARY OF THE INVENTION

Sputtering targets made of IGZO sintered bodies can be obtained by controlling the raw material powder particle size, maximum sintering temperature, holding time, sintering atmosphere, and the like so that the crystal grain size is below a certain level and the relative density is above a certain level. IGZO sintered bodies are usually made by pulverizing the raw material $In_2O_3$, ZnO, and $Ga_2O_3$ powders in a bead mill to make them fine particles, which makes the structure denser and improves the density of the sintered bodies. However, zirconia beads are usually used for bead milling, and these zirconia beads are worn out during the bead milling process and may end up being mixed into the raw material powder as inevitable impurities. Contamination with impurities may cause an increase in particles due to arcing during sputtering, a decrease in the transmittance of the IGZO film, and a decrease in the mobility of the TFT element.

The invention according to Patent Literature 1 attempts to obtain an IGZO sintered body that has high density and bending strength and has few cracks even when used in a sputtering target by containing zirconium in an amount of 20 ppm or more and less than 100 ppm by weight in an IGZO sintered body having a homologous crystal structure represented by $InGaZnO_4$. However, since zirconia (Zr) is intentionally added as an impurity to obtain the relative density and strength of the sintered body, arcing and particles are expected to occur during sputtering. Lowering the Zr content in turn eliminates the relative density and strength benefits.

Further, in the invention according to Patent Literature 1, the dispersion treatment was performed using a wet bead mill using zirconia beads, so as described above, it is thought that the zirconia beads are mixed into the raw material powder as an inevitable impurity.

The present invention was completed in view of the above problems, and in one embodiment, an object of the present invention is to provide an IGZO sputtering target with a high relative density while suppressing increase in arcing and particles during sputtering.

As a result of extensive studies, the present inventors have found that by optimizing a method of pulverizing the raw material powder of the IGZO sputtering target, it is possible to obtain an IGZO sputtering target with a high relative density while suppressing the incorporation of Zr. The present invention was completed based on this knowledge, and is exemplified as below.

[1] An IGZO sputtering target, comprising indium (In), gallium (Ga), zinc (Zn), zirconium (Zr), and oxygen (O), the rest consisting of inevitable impurities, wherein the IGZO sputtering target comprises Zr at less than 20 mass ppm and has a relative density is 95% or more.

[2] The IGZO sputtering target according to [1], wherein the relative density is 98% or more.

[3] The IGZO sputtering target according to [1] or [2], wherein a bulk resistance is 100 mΩ·cm or less.

[4] The IGZO sputtering target according to any one of [1] to [3], wherein an average crystal grain size is 30 μm or less.

[5] The IGZO sputtering target according to [4], wherein the average crystal grain size is 12 μm or less.

[6] The IGZO sputtering target according to any one of [1] to [5], wherein a bending strength is 100 MPa or more.

[7] The IGZO sputtering target according to any one of [1] to [6], wherein the IGZO sputtering target has a disc shape, a rectangular plate shape, or a cylindrical shape.

According to the present invention, it is possible to provide an IGZO sputtering target with a high relative density while suppressing increase in arcing and particles during sputtering.

## DETAILED DESCRIPTION OF THE INVENTION

Hereinafter, embodiments of the present invention will now be described in detail with reference to the drawings. It should be understood that the present invention is not intended to be limited to the following embodiments, and any change, improvement or the like of the design may be appropriately added based on ordinary knowledge of those skilled in the art without departing from the spirit of the present invention.

(1. Composition)

In one embodiment, the IGZO sputtering target according to the present invention comprises indium (In), gallium (Ga), zinc (Zn), zirconium (Zr), and oxygen (O), with the rest consisting of inevitable impurities, and comprises Zr at less than 20 mass ppm.

Inevitable impurities are impurities that exist in raw materials or are inevitably mixed in during the manufacturing process, and are originally unnecessary, but are in trace amounts and do not have a major negative impact on the characteristics of the product, and therefore tolerated. In the IGZO sputtering target according to the present invention, typical inevitable impurities include inevitable impurities contained in the raw materials $In_2O_3$ powder, $Ga_2O_3$ powder, and ZnO powder, inevitable impurities mixed in during the pulverization process, and inevitable impurities contained in forming aids. In the IGZO sputtering target according to the present invention, the total concentration of inevitable impurities can be, for example, 100 mass ppm or less, preferably 50 mass ppm or less, and more preferably 30 mass ppm or less. The lower limit of the total concentration of inevitable impurities is not particularly limited, but from the viewpoint of manufacturing cost, it can be set to, for example, 10 mass ppm or more, and typically 30 mass ppm or more. When the total concentration of inevitable impurities in the IGZO sputtering target is low, it is possible to prevent the properties (conductivity, transparency, and the like) of the IGZO film obtained by sputtering the target from being adversely affected.

In one embodiment of the invention, herein the total concentration of inevitable impurities means the total concentration of Li, Be, B, Na, Mg, Al, Si, S, Cl, K, Ca, Ti, Cr, Mn, Fe, Co, Ni, Cu, Zn, Ga, As, Y, Nb, Mo, Cd, Sb, Ba, Hf, W, Pb, and Bi. Although Zr can be regarded as an inevitable impurity, it is discussed separately for convenience because the concentration of Zr is particularly controlled in the present invention.

In the IGZO sputtering target according to the present invention, the Zr concentration can be, for example, less than 20 mass ppm, preferably 19 mass ppm or less, more preferably 18 mass ppm or less, even more preferably 17 mass ppm or less, even more preferably 16 mass ppm or less, even more preferably 15 mass ppm or less, even more preferably 14 mass ppm or less, even more preferably 13 mass ppm or less, even more preferably 12 mass ppm or less, even more preferably 11 mass ppm or less, and even more preferably 10 mass ppm or less. By controlling the Zr concentration low, it is possible to suppress arcing and increase in particles during sputtering.

Although no lower limit is set for the Zr concentration, it is generally 1 mass ppm or more, typically 5 mass ppm or more, in consideration of the cost of completely eliminating Zr.

The concentration of Zr is measured by high-frequency inductively coupled plasma optical emission spectrometry (ICP-OES), and each metal element is analyzed using a pretreated measurement solution using a part of the sputtering target member as a sample. The concentration of other unavoidable impurities is measured by glow discharge mass spectrometry (GDMS), and various elements are analyzed by a Ta electrode method in which high-purity Ta is discharged together with the measurement sample.

(2. Relative density)

The relative density of the sputtering target is desirably high, since it affects the occurrence of arcing and particles during sputtering. It is also preferable that the sputtering target has a high relative density from the viewpoint of suppressing the occurrence of cracks or fractures in the sputtering target. In one embodiment, the IGZO sputtering target according to the present invention has a relative density of 95% or more. The relative density is preferably 98% or more, more preferably 99% or more, even more preferably 99.5% or more, and even more preferably 99.6% or more. Although the upper limit of the relative density is not particularly limited, it can be set to, for example, 99.99% or less, and can also be set to 99.9% or less, from the viewpoint of manufacturing cost.

In the present invention, "relative density" is expressed as relative density = (measured density / theoretical density) $\times$ 100 (%). The theoretical density is a density value calculated from the theoretical density of oxides of elements excluding oxygen in each constituent element of a sintered body. In the case of the IGZO sputtering target in the present invention, Among the constituent elements In, Ga, Zn, and O, indium oxide ($In_2O_3$), gallium oxide ($Ga_2O_3$), and zinc oxide (ZnO), excluding O, are used as oxides of elements for calculating the theoretical density. The elemental analysis values (at%, or mass %) of In, Ga, and Zn of the IGZO sputtering target are converted into mass ratios of indium oxide ($In_2O_3$), gallium oxide ($Ga_2O_3$), and zinc oxide (ZnO). The density of each oxide is $In_2O_3$: 7.18 g/cm$^3$, $Ga_2O_3$: 5.88 g/cm$^3$, and ZnO: 5.61 g/cm$^3$. On the other hand, the measured density is the value obtained by dividing the weight by the volume. In the case of a sintered body, the volume is calculated using the Archimedes method.

(3. Bulk resistance)

It is preferred that the bulk resistance of the IGZO sputtering target is sufficiently low to enable stable DC sputtering. In one embodiment, the IGZO sputtering target of the present invention has a bulk resistance of 100 mΩ·cm or less. This enables stable DC sputtering and suppresses abnormal discharge during sputtering. From this viewpoint, the bulk resistance of the IGZO sputtering target is preferably 80 mΩ·cm or less, more preferably 60 mΩ·cm or less.

In the present invention, the bulk resistance is determined by a four-probe method. An average value is obtained by dividing the sum of the measurement results of samples taken at three locations apart from each other from the IGZO sputtering target by the number of measurement locations.

(4. Average crystal grain size)

The IGZO sputtering target of the present invention preferably has an average crystal grain size of 30 $\mu$m or less. Mechanical strength can be increased by setting the average crystal grain size within the above numerical range. From this point of view, the average crystal grain size of the IGZO sputtering target is more preferably 20 $\mu$m or less, even more preferably 15 $\mu$m or less, even more preferably 12 $\mu$m or less, and even more preferably 10 $\mu$m or less.

The method for measuring the average crystal grain size is as follows. The IGZO sputtering target is observed using FE-SEM, the crystal grain size is measured, and the average value is calculated. A code method is used to measure the average crystal grain size. In the code method, a straight line is drawn from grain boundary to grain boundary in an arbitrary direction on a SEM image, and the average length of this line crossing one grain is taken as the average crystal grain size. An arbitrary straight line (from grain boundary to grain boundary) is drawn on the SEM image, the number of intersections with the grain boundary is counted, and calculation is performed using the following (Formula 1).

Average grain size = length of straight line / number of intersections (Formula 1)

Specifically, three mutually parallel lines of arbitrary length are drawn for each field of view on a SEM image of six fields of view at a magnification of 2000 times, and the average crystal grain size is calculated from the average of the total length of the lines and the total number of intersections with grain boundaries.

The sample is mirror polished. The SEM image is taken with FE-SEM (manufactured by JEOL Ltd.). In addition, as for the sample collection location, a size of 10 mm × 10 mm × thickness is cut out from the center of the sintered body. Then, when the size of the sample is defined as length (Y mm) × width (X mm) × thickness (Z mm), the following points are measured with reference to the 1/2 position in each of the length and width.

-2 locations from the intersections of the Y/4 mm axis and the X/4, X/2, 3X/4 mm axes, 2 locations from the intersections of the Y/2 mm axis and the X/4, X/2, 3X/4 mm axes, 2 locations from the intersections of the 3Y/4 mm axis and the X/4, X/2, 3X/4mm axes are selected.

(5. Bending strength)

The IGZO sputtering target of the present invention preferably has a bending strength of 100 MPa or more. By setting the bending strength to 100 MPa or more, it is possible to suppress the phenomenon in which cracks occur in the sputtering target during sputtering. From this viewpoint, the bending strength of the IGZO sputtering target is more preferably 120 MPa or more, and even more preferably 140 MPa or more.

The bending strength is measured by a three-point bending test in accordance with JIS R1601: 2008. Specifically, sample total length: 40 mm ± 0.1 mm, width: 4 mm ± 0.1 mm, thickness: 3 mm ± 0.1 mm, distance between fulcrums: 30 mm ± 0.1 mm, crosshead speed: 0.5 mm/min.

(6. Manufacturing method)

Below, a preferred method for manufacturing an IGZO sputtering target according to the present invention will be exemplified.

Powders

[1] Powders containing each of In, Ga, and Zn can be used. More specifically, In compound powder, Ga compound powder, and Zn compound powder can be used. Alternatively, powder containing a combination of these elements may be used. Examples of the In compound powder include indium oxide ($In_2O_3$) and indium hydroxide. Examples of Ga compound powder include gallium oxide ($Ga2O_3$) and gallium nitrate. Examples of Zn compound powder include zinc oxide (ZnO), zinc hydroxide, and the like. The formulation amount may be any amount that can achieve the desired atomic ratio of In, Ga, and Zn.

[2] Fine pulverization and mixing

Next, these raw material powders are finely pulverized and mixed. A dry method or a wet method can be used for finely pulverization and mixing the raw material powder. The dry method includes a dry method using balls or beads made of zirconia, alumina, nylon resin, or the like. On the other hand, the wet method includes a media stirring type mill using the above-mentioned balls or beads. Furthermore, the wet method includes a media-less container rotation method, a mechanical stirring method, and an airflow method. Here, the wet method generally has better fine pulverization and mixing ability than the dry method. Therefore, it is preferable to perform fine pulverization and mixing using a wet method.

However, in order to control the amount of Zr contained in the IGZO sputtering target to less than 20 mass ppm, at least the Ga compound powder, preferably all the raw material powders, are pulverized with a medialess dry pulverization device. Examples of medialess dry pulverization devices include compressed air dry pulverization devices and superheated steam dry pulverization devices. By using a medialess dry pulverization device, the use of zirconia beads can be avoided. Therefore, since contamination due to wear of the zirconia beads can be prevented, the amount of Zr contained in the IGZO sputtering target can be reduced.

In this specification, a superheated steam dry pulverization device is a dry pulverization device which uses superheated steam thereby not only allowing for higher collision energy compared to compressed air, but also prevents the contamination of zirconia beads.

There are no particular restrictions on the size of the particles after the pulverization, but a small size is preferable, as finer raw material powder can yield a high-density sintered body, have high electrical conductivity, and suppress nodules during sputtering. Therefore, after the pulverization, the volume-based median diameter (D50) of the raw material powder determined by the laser diffraction / scattering method is preferably 1.0 $\mu$m or less, more preferably 0.5 $\mu$m or less. In addition, if the pulverization is insufficient, various components will segregate in the manufactured target, resulting in the existence of high resistivity regions and low resistivity regions. This causes abnormal discharge such as arcing during sputtering film formation due to charging in a high resistivity region. Therefore, sufficient mixing and pulverization are necessary.

[3] Granulation

When mixing is performed using a wet method, a forming aid is added to the mixed powder slurry obtained in the above step, and then granulated powder is produced using a spray dryer. By improving the fluidity of the powder through granulation, the powder can be evenly filled into the mold during the next step of press molding, and a homogeneous formed product can be obtained. There are various methods for granulation, but a method using a spray dryer is preferred. In this method, slurry is dispersed as droplets in hot air and dried instantly, and spherical granulated powder can be continuously obtained. The granulated powder preferably has a volume-based median diameter (D50) of 35 to 65 $\mu$m, more preferably 40 to 60 $\mu$m, and even more preferably 45 to 55 $\mu$m, as determined by the laser diffraction / scattering method.

The addition ratio of the forming aid is suitably 50 to 250 cc per 1 kg of the mixed powder slurry. The addition ratio of the molding aid is preferably 100 cc or more, more preferably 120 cc or more per 1 kg of the mixed powder slurry, in order to obtain sufficient strength of the formed product. The addition ratio of the forming aid is preferably 175 cc or less, more preferably 150 cc or less per 1 kg of the mixed powder slurry, since the forming aid may inhibit sintering and causes a decrease in the density of the sintered body.

[4] Forming

Next, the mixed powder is filled into a mold and uniaxially pressed under conditions of a surface pressure of 400 to 1000 kgf/cm$^2$ and held for 1 to 3 minutes to obtain a formed body. If the surface pressure is less than 400 kgf/cm$^2$, a formed article with sufficient density cannot be obtained. In addition, a surface pressure exceeding 1000 kgf/cm$^2$ is not particularly required for production. That is, even if an excessive surface pressure is applied, it becomes difficult to improve the density of the formed product beyond a certain value. Further, if a surface pressure of more than 1000 kgf/cm$^2$ is applied, density distribution tends to occur in the compact in principle in uniaxial pressing, which may cause deformation or cracking during sintering.

Next, this formed body is vacuum-packed in double layers with vinyl and subjected to CIP (cold isostatic pressing) at a pressure of 1,500 to 4,000 kgf/cm$^2$ and held for 1 to 3 minutes. If the pressure is less than 1500 kgf/cm$^2$, sufficient CIP effects cannot be obtained. On the other hand, even if a pressure of more than 4000 kgf/cm$^2$ is applied, the density of the formed product is difficult to improve beyond a certain value. Therefore, a surface pressure exceeding 4000 kgf/cm$^2$ is not particularly required for production. Although the size of the formed body is not particularly limited, if the thickness is too large, it will be difficult to obtain a sintered body with a high relative density. Therefore, it is preferable to adjust the thickness of the formed body so that the thickness of the sintered body is 15 mm or less.

[5] Sintering

Next, the formed body is sintered at a temperature of 1300 to 1500 °C (preferably 1350 to 1450 °C) for 5 to 24 hours (preferably 10 to 22 hours, more preferably 15 to 21 hours) in an air atmosphere or an oxygen atmosphere to obtain a sintered body. If the sintering temperature is lower than 1300 °C, a sintered body with sufficient density cannot be obtained, and further, it is not possible to obtain a sufficient amount of crystal phase $InGaZnO_4$. If the sintering temperature exceeds 1500 °C, the size of crystal grains in the sintered body becomes too large, which may reduce the mechanical strength of the sintered body. Further, if the time is less than 5 hours, a sintered body with sufficient density cannot be obtained, and if the time is longer than 24 hours, it is not preferable from the viewpoint of production cost.

The temperature rising rate in the sintering process is preferably 1 to 10 °C/min. This is because if the temperature rising rate is too slow, grains will grow before densification progresses sufficiently and densification will not be achieved. Further, the temperature rising rate in the sintering step is preferably 3 to 8 °C/min, more preferably 4 to 6 °C/min. Further, the temperature decreasing rate in the sintering step is preferably 20 °C/min or less, more preferably 10 °C/min or less. This is because if the temperature decreasing rate is too fast, the sintered body may be damaged due to thermal shock.

Further, in the forming / sintering process, in addition to the methods described above, HP (hot press) and HIP (hot isostatic pressing) can be used.

[6] Grinding

The sintered body obtained by the above steps can be finished into an IGZO sputtering target by processing it into a desired shape with a processing machine such as a surface grinder, a cylindrical grinder, or a machining machine, if necessary. The shape of the IGZO sputtering target is not particularly limited, but may be, for example, disc-shaped, rectangular plate-shaped, or cylindrical. The IGZO sputtering target may be used alone or may be used by being bonded to a backing plate as appropriate. As a method for bonding with the backing plate, for example, a method of bonding an indium alloy or the like as a bonding metal to a copper backing plate can be mentioned.

Through the above steps, the IGZO sputtering target targeted by the present invention can be obtained.

**EXAMPLES**

Hereinafter, description will be given based on Examples and Comparative Examples. It should be noted that these Examples are merely for illustration, and the present invention is not limited to these Examples.

$In_2O_3$ powder, $Ga_2O_3$ powder, and ZnO powder were weighed so that the composition ratio of the sintered body was approximately 1:1:1 in terms of the atomic ratio of In, Ga, and Zn, and then these raw material powders were pulverized and mixed under the conditions shown in Table 1. Thereafter, the mixed raw material powder was dispersed in pure water to prepare a slurry with a solid content of 45 to 50% by mass, and the slurry was dried and granulated using a spray dryer (manufactured by Okawara Kakoki Co., Ltd., device name: FOC-25E) to obtain a mixed powder. Next, this mixed powder was uniaxially pressed at a surface pressure of 400 to 1000 kgf/cm$^2$ to obtain a disc-shaped compact with a diameter of 280 mm. Next, the obtained formed body was sintered under the conditions shown in Table 1.

As shown in Table 1, a wet bead mill or a superheated steam dry pulverization device was used as a means for finely pulverizing and mixing the raw material powder. The conditions for each are as follows.

(Conditions for wet bead mill)

A raw material powder was prepared and dispersed in pure water to prepare a slurry with a solid content of 45% by mass (for Comparative Example 1, only $Ga_2O_3$ powder was used). Next, $ZrO_2$ beads as a grinding medium was put into a bead mill (manufactured by Ashizawa Finetech Ltd., device name: LMZ), and pulverization was performed until the median diameter (D50) of the mixed powder reached the value listed in Table 1 according to the test numbers, and mixed powder slurry according to each test number was obtained.

(Conditions for superheated steam dry pulverization device)

$Ga_2O_3$ powder was prepared, and grinding was carried out with a crushing steam pressure of 3.8 MPa, a classifier speed of 7000 rpm, and a crushing steam temperature of 250 to 340 °C until the median diameter (D50) of the $Ga_2O_3$ powder reached the value shown in Table 1 according to the test numbers to obtain a $Ga_2O_3$ pulverized powder.

(Median diameter (D50))

Further, for each raw material powder after the pulverization, the cumulative distribution of particle size on a volume basis was measured using a laser diffraction / scattering particle size measuring device (manufactured by Horiba, Ltd., device name: LA-960), and the median diameter (D50) was measured. Measurements were made using alcosol as a dispersant and setting the refractive index to 1.9. For Examples where "None" is indicated as the pulverization method, the median diameter (D50) of the raw material powder was directly shown. Regarding the Examples indicated as "Wet bead mill" as the pulverization method, the median diameter (D50) of the mixed powder slurry of $In_2O_3$, ZnO, and $Ga_2O_3$ after the pulverization and mixing was measured. Regarding the Example indicated as "Wet bead mill (Note)" as the pulverization method, the pulverization time is halved compared to "Wet bead mill", and the median diameter (D50) of the mixed powder slurry of $In_2O_3$ and ZnO after the pulverization and mixing was measured. In each of the Examples and Comparative Examples, $Ga_2O_3$ powder having a median diameter (D50) of 2.17 $\mu$m was used.

(Relative density)

The measured density of the IGZO sputtering target according to each test number obtained above was determined by the Archimedes method, and the relative density was determined by the formula of relative density = measured density / theoretical density $\times$ 100 (%) according to the method described above. The results are shown in Table 1.

(Average crystal grain size)

The average crystal grain size of the IGZO sputtering target according to each test number obtained above was measured according to the method described above. The results are shown in Table 1.

(Bulk resistance)

The bulk resistance of the IGZO sputtering target according to each test number obtained above was measured according to the method described above. The results are shown in Table 1.

(Bending strength)

Regarding Example 7, the bending strength of the IGZO sputtering target according to each test number obtained above was measured according to the method described above. As a result, the bending strength of Example 7 was 160.9 MPa.

(Zr content)

The Zr concentration in the IGZO sputtering target according to each test number obtained above was measured by high frequency inductively coupled plasma optical emission spectrometry (ICP-OES) under the conditions described above. The results are shown in Table 1. In addition, in the table, "<" indicates that it is less than the detection limit.

Table 1

| | | Example 1 | Example 2 | Example 3 | Example 4 | Example 5 | Example 6 | Example 7 | Compartive Example 1 | Compartive Example 2 | Compartive Example 3 | Compartive Example 4 | Compartive Example 5 |
|---|---|---|---|---|---|---|---|---|---|---|---|---|---|
| Pulverization method | $In_2O_3$ | None | None | Wet bead mill (Note) | Wet bead mill | | | | Wet bead mill | Wet bead mill (Note) | None | Wet bead mill | None |
| | ZnO | | Wet bead mill (Note) | None | | | | | | | Wet bead mill | None | |
| | $Ga_2O_3$ | Superheated steam dry pulverization device | | | | | | | | None | | | |
| Sintering conditions | | 1360 °C 20hr Oxygen atmosphere | | | | | | 1320 °C 20hr Oxygen atmosphere | 1360 °C 20hr Oxygen atmosphere | | | | |
| D50 after pulverization ($\mu$m) | $In_2O_3$ | 1.534 | 1.534 | 0.266 | | | | | 0.155 | 0.266 | 1.534 | 0.155 | 1.534 |
| | ZnO | 0.726 | 0.312 | 0.726 | | | | | 0.335 | 0.312 | 0.335 | 0.726 | 0.726 |
| | $Ga_2O_3$ | 0.436 | 0.436 | 0.436 | 0.43 | 0.478 | 0.420 | 0.43 | 0.367 | 2.17 | 2.17 | 2.17 | 2.17 |
| | Mixed slurry | | | | 0.673 | 0.435 | 0.486 | 0.673 | | | | | |
| Archimedes density (g/cm$^3$) | | 6.326 | 6.286 | 6.33 | 6.323 | 6.325 | 6.268 | 6.291 | 6.351 | 5.687 | 5.965 | 5.722 | 4.853 |
| Relative density (%) | | 99.56 | 98.93 | 99.62 | 99.51 | 99.54 | 98.65 | 99.01 | 99.95 | 89.5 | 93.88 | 90.05 | 76.38 |
| Average crystal grain size ($\mu$m) | | 8.65 | 9.95 | 9.96 | 9.54 | 11.36 | 8.06 | 4.94 | 7.94 | Not measurable | Not measurable | Not measurable | Not measurable |
| Bulk resistance (m$\Omega\cdot$cm) | | 44.53 | 45.55 | 42.81 | 49.4 | 50.2 | 5.095 | 57.61 | 51.89 | $1251.5 \times 10^3$ | $1920.2 \times 10^3$ | $17.83 \times 10^3$ | Not measurable |
| Zr content (mass ppm) | | <10 | <10 | 19 | 19 | 14 | 17 | 19 | 130 | 19 | <10 | 41 | <10 |

(Discussion)

As can be seen from Table 1, in each Example, by pulverizing the $Ga_2O_3$ powder not with a wet bead mill but with a superheated steam dry pulverization device, the contamination of Zr could be suppressed, and the Zr content of the resulting IGZO sputtering target was less than 20 mass ppm. Furthermore, the IGZO sputtering targets of each Example had a relative density of 95% or more, a bulk resistance of 100 mΩ·cm or less, and an average crystal grain size of 30 μm or less.

On the other hand, when the $Ga_2O_3$ powder was pulverized using a wet bead mill, the Zr content of the finally obtained IGZO sputtering target was greatly increased (Comparative Example 1). When producing an IGZO sputtering target without pulverizing the $Ga_2O_3$ powder at all, it was possible to prevent the incorporation of Zr, but because the particle size of the raw material powder was high, it was not possible to achieve a relative density of 95% or higher (Comparative Examples 2 to 5).

**Claims**

1. An IGZO sputtering target, comprising indium (In), gallium (Ga), zinc (Zn), zirconium (Zr), and oxygen (O), the rest consisting of inevitable impurities, wherein the IGZO sputtering target comprises Zr at less than 20 mass ppm and has a relative density is 95% or more.

2. The IGZO sputtering target according to claim 1, wherein the relative density is 98% or more.

3. The IGZO sputtering target according to claim 1 or 2, wherein a bulk resistance is 100 mΩ·cm or less.

4. The IGZO sputtering target according to any one of claims 1 to 3, wherein an average crystal grain size is 30 μm or less.

5. The IGZO sputtering target according to claim 4, wherein the average crystal grain size is 12 μm or less.

6. The IGZO sputtering target according to any one of claims 1 to 5, wherein a bending strength is 100 MPa or more.

7. The IGZO sputtering target according to any one of claims 1 to 6, wherein the IGZO sputtering target has a disc shape, a rectangular plate shape, or a cylindrical shape.

## INTERNATIONAL SEARCH REPORT

| | International application No. |
|---|---|
| | **PCT/JP2022/033015** |

### A. CLASSIFICATION OF SUBJECT MATTER

*C23C 14/34*(2006.01)i; *C04B 35/01*(2006.01)i
FI: C23C14/34 A; C04B35/01

According to International Patent Classification (IPC) or to both national classification and IPC

### B. FIELDS SEARCHED

Minimum documentation searched (classification system followed by classification symbols)

C23C14/34; C04B35/01

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2009/148154 A1 (IDEMITSU KOSAN CO., LTD.) 10 December 2009 (2009-12-10) claims, paragraphs [0018], [0049], [0054], [0083], [0113]-[0118], tables 6, 7 | 1-7 |
| Y | | 1-7 |
| X | JP 2014-224036 A (SUMITOMO CHEMICAL CO) 04 December 2014 (2014-12-04) claims, paragraphs [0014], [0054], [0063] | 1-3, 7 |
| Y | | 1-7 |
| Y | JP 2014-24738 A (TOSOH CORP) 06 February 2014 (2014-02-06) paragraphs [0023], [0043], [0046], [0050], table 1 | 1-7 |

☐ Further documents are listed in the continuation of Box C.   ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **27 October 2022** | **08 November 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2022/033015**

| Patent document cited in search report | | | Publication date (day/month/year) | Patent family member(s) | | | Publication date (day/month/year) |
|---|---|---|---|---|---|---|---|
| WO | 2009/148154 | A1 | 10 December 2009 | US | 2011/0168994 | A1 | |
| | | | | claims, paragraphs [0073], [0178]-[0180], [0193], [0296]-[0300], [0388]-[0405], tables 6-7 | | | |
| | | | | US | 2013/0285053 | A1 | |
| | | | | KR | 10-2011-0020901 | A | |
| | | | | CN | 102105619 | A | |
| | | | | KR | 10-2013-0080063 | A | |
| | | | | TW | 201011115 | A | |
| | | | | CN | 103233204 | A | |
| | | | | TW | 201402852 | A | |
| | | | | JP | 2013-100224 | A | |
| | | | | JP | 2013-147423 | A | |
| JP | 2014-224036 | A | 04 December 2014 | (Family: none) | | | |
| JP | 2014-24738 | A | 06 February 2014 | WO | 2014/021334 | A1 | |
| | | | | TW | 201410904 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014024738 A
- JP 2015024944 A
- JP 2007223849 A